# EUROPEAN PATENT APPLICATION

(11) **EP 2 562 549 A1**
(43) Date of publication of application: **27.02.2013**
(21) Application number: 10850039.8
(22) Date of filing: 20.04.2010
(51) Int. Cl.: G01R 15/00, G01R 19/00, H02H 9/04

(54) **PULSE CURRENT SENSOR AND LIGHTNING PROTECTION CABINET WITH SURGE WAVE RECORDING COMPOSED OF THE SENSOR**

(71) Applicant: Anyang Anke Electric Co., Ltd., Anyang, Henan 455000 (CN); Liang, Huaijun, Anyang, Henan 455000 (CN); Yuan, Ying, Anyang, Henan 455000 (CN)
(72) Inventor: LIANG, Huaijun, Anyang Henan 455000 (CN); YUAN, Ying, Anyang Henan 455000 (CN)
(74) Representative: Desormiere, Pierre-Louis
(86) International application number: PCT/CN2010/071901
(87) International publication number: WO 2011/130905

(57) **Abstract**

The present invention relates to a kind of pulse current sensor including a pair of semi-circular magnetic cores (22) which are installed oppositely, air gaps (30) between the two semi-circular magnetic cores (22), and a pair of nonmagnetic conductive metal rings (29) respectively sleeved outside the corresponding air gaps (30); wherein the inner hole axes of the nonmagnetic conductive metal rings (29) are consistent with the magnetic force lines of the semi-circular magnetic cores (22), and wherein coils (23) are wound around the semi-circular magnetic cores (22), with output terminals (31) led out from the coils (23).

## Description

### Field of the Invention

The present invention relates to a kind of lightning protection cabinet with surge wave recording, especially a kind of lightning protection cabinet with the function of recording and retrieval of the current waveforms of lightning stroke surge or electric surge.

### Description of Prior Art

At present, a commonly known lightning protection cabinet is composed of housing, wiring terminals, conductive connecting lines, electrodes, semiconductor chips, mechanical thermal trip device, indicating device, counting device, peak current display device and mounting fixture. To fulfill its function, a plurality of such lightning protection cabinets are to be respectively mounted between phase line and grounding line, and between zero line and grounding line as well, in the power distribution system. When a voltage surge or a lightning surge occurs in the power distribution system and the value of such surge is high enough to actuate the semiconductor chips to be in conducting state, the impedance of the chips will drop abruptly to make the chips become a low-impedance conductor, whereby to allow discharging to ground, and at the same time the voltage value of the electric surge in the power distribution system also drops abruptly. When the voltage decreases to a predetermined normal voltage as the to-ground discharging proceeds, the impedance of the semiconductor chips will increase abruptly to make the chips into non-conducting state, namely equal to an insulator, whereby to make the voltage of the power distribution system return to normal, thereby removing the overvoltage in the power distribution system. The peak current value and occurrence time will be displayed on the display device. Such event will be counted once in the counter. However, with the higher requirements on the electric power quality from the electric equipments and electronic equipments, the people concerned have to know about the electric surge as noise wave occurring in the power circuit and signal circuit, especially about the width, shape, amplitude, energy and occurrence time of the electric surge wave. However, only based on the display of current value, occurrence time and number of times, the wave pattern of the electric surge or the lightning surge can never be identified and distinguished apart from each other; thus the accidents caused by such electric surge or the lightning surge can not be correctly analyzed; the energy magnitude involved in such process can not be displayed and the accidents thereof can not be comprehensively evaluated.

### The Summary of the Invention

To remove the existing lightning protection cabinet's disadvantage of not unabling to identify and record the wave pattern and energy magnitude of electric surge or lightning strike surge, the present invention hereby discloses a kind of lightning protection cabinet, which is able to record complete overvoltage wave pattern. Such lightning protection cabinet can identify and record the occurrence time, waveform pattern and other parameters of the overvoltage that is triggered off every time when the electric surge or the lightning strike surge passes through the system, thereby solving the problem that the existing lightning protection cabinets are unable to record the wave pattern, and consequently the accidents caused by specific electric surge or the lightning strike surge can not be correctly analyzed and evaluated.

For solving the above-mentioned problems, the present invention adopted following technical solutions:

In the present invention, a kind of pulse current sensor is provided, comprising: a pair of semi-circular magnetic cores which are installed oppositely, air gaps between the two semi-circular magnetic cores, a pair of nonmagnetic conductive metal rings respectively sleeved outside the corresponding air gaps; the inner hole axes of said nonmagnetic conductive metal rings being consistent with the magnetic force lines of the semi-circular magnetic cores, and wherein coils are wound around the semi-circular magnetic cores, with output terminals led out from the coils.

The semi-circular magnetic are supposed to be mounted in the cavity that is formed by the insulating frame and the magnetic shielding housing.

A conducting pole is mounted on the insulating frame.

In the present invention, a kind of lightning protection cabinet, which adopts the above-mentioned pulse current sensor and has the function of surge wave pattern recording, comprises: a plurality of switches, thermal trip relays and electrodes, all of which are respectively installed in series connection with every phase line and zero line, and semiconductor chips disposed between the two poles of the corresponding electrode. Said phase lines and zero line are all connected with grounding line; the pulse current sensor is mounted on said grounding line and connected with MCU through A/D conversion interface. Said MCU is connected with a display screen.

Said MCU is connected with a computer system through telecommunication interface and the computer system is connected with display equipment and printer.

Said telecommunication interface is RS232 interface.

Said MCU is also connected with a back-up battery.

Failure indicators and normal-working indicators are installed on each aforementioned phase line and zero line.

In the present invention adopting the above-mentioned technical scheme, the pulse current sensor is disposed on the grounding line and the two nonmagnetic conductive metal rings are respectively installed in the two symmetrical air gaps between the two semi-circular magnetic cores. Under the action of the two semi-circular magnetic cores, the phenomenon of magnetic saturation does not occur in the pulse current sensor, and the output precision and the output range of the pulse current sensor are consequently improved, whereby solid foundation for displaying complete voltage waveform is provided. Moreover, such pulse current sensor demonstrates improved detection sensitivity and measurement error. Based on the above-mentioned technical scheme, when an electric surge or a lightning strike surge occurs, the semiconductor chips will be actuated to be in conducting state, whereby electric discharging to ground along grounding line is allowed. The data acquired by the pulse current sensor that is mounted on the grounding line undergo one process of voltage division by resistance voltage divider, isolated amplification, level conversion, A/D conversion, and meantime undergo the other process of front isolation, trigger comparison, COLD control, later the processed data will be stored in the FLASH memory through the processing of MCU and will be displayed on the screen. The computer software system can transmit the fully recorded waveform pattern, time, and other parameters to the computer. All the recorded data can be displayed, item by item, on the monitor having parametric coordinate system. The waveform, real time and history records can be printed out. Based on the above-mentioned processes, the accidents caused by some electric surge or lightning surge can be visually analyzed and judged.

### Description of the Drawings

Fig.1 is the electrical schematic diagram of a pulse current sensor according to the present invention.
Fig.2 is the overall schematic diagram of a pulse current sensor according to the present invention.
Fig.3 is the sectional view in A-A direction of Fig.2
Fig.4 is the schematic diagram of a lightning protection cabinet with surge wave recording according to the present invention.
Fig.5 is the electric frame diagram of a lightning protection cabinet with surge wave recording according to the present invention.
Fig.6 is the current wave pattern acquisition flow chart of a lightning protection cabinet with surge wave recording according to the present invention.
Fig.7 is the graphic of finally acquired current wave pattern.

### Detailed Description of the Embodiments

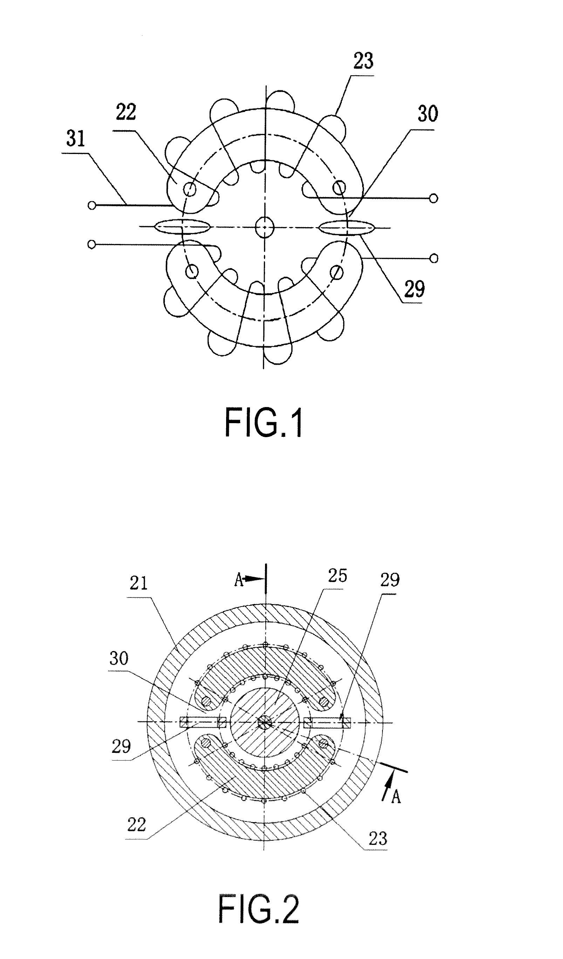

As illustrated in Fig.1, in this embodiment, the pulse current sensor comprises: a pair of semi-circular magnetic cores 22 which are installed oppositely, air gaps 30 between the two semi-circular magnetic cores 22, and a pair of nonmagnetic conductive metal rings 29 respectively sleeved outside the corresponding air gaps 30; the inner hole axes of said nonmagnetic conductive metal rings 29 being consistent with the force lines of the semi-circular magnetic cores 22, and wherein coils 23 are wound around the semi-circular magnetic cores 22, with output terminals 31 led out from the coils 23. It should be pointed out that the semi-circular magnetic cores 22 in the present invention may have the shape approximately similar to semicircle, namely: said magnetic cores 22 can be a pair of standard semicircles with air gaps 30 between them; further, said magnetic cores 22 can also be a pair of circular arcs slightly smaller than semicircle, with air gaps 30 between the two circular arcs.

Said pulse current sensor is the modified edition of Rogowski coil, with the degaussing mechanism described as follows:

Firstly, the magnetic core in the form of a complete and closed circle is changed into two semi-circular magnetic cores 22. A magnetic circuit is composed of two such semi-circular magnetic cores 22 and two air gaps 30. Since the magnetic reluctance of the two air gaps is much higher than that of the two semi-circular magnetic cores 22, most of the magnetic field energy is concentrated into air gaps 30, so as to withstand greater magnetic field intensity compared with original one; Secondly, the air gaps 30 pass through the two nonmagnetic conductive metal rings 29 along with the centerline of the magnetic circuit and are enclosed in radial direction by such two nonmagnetic conductive metal rings 29, therefore when a magnetic field appears along with the aforementioned magnetic circuit that is composed of said two semi-circular magnetic cores 22 and two air gaps 30, annular electric current will appear in radial direction in the two nonmagnetic conductive metal rings 29. However, the direction of the magnetic field generated by the annular electric current in the two nonmagnetic conductive metal rings 29 is opposite to the direction of the original magnetic field, therefore the magnetic field intensity in the magnetic circuit can be partly counteracted; lastly, considering that there is annular electric current in radial direction in the two nonmagnetic conductive metal rings 29 and the two air gaps 30 have intrinsic resistance, once the current passes, Joule heat will be produced to raise the temperature of the two nonmagnetic conductive metal rings 29, namely, the magnetic field energy in the two air gaps is turned into heat energy by means of the two nonmagnetic conductive metal rings 29, so as to withstand magnetic field intensity compared with original one. Therefore, under the action of the two semi-circular magnetic cores 22, the two air gaps 30 and the two nonmagnetic conductive metal rings 29, the phenomenon of magnetic saturation will not occur as long as the magnetic field intensity does not exceed the predetermined value Consequently the performances of the pulse current sensor 17 are improved concerning output precision, output range, detection sensitivity and measurement error. Further, such pulse current sensor 17 can acquire peak value of current and the specific current values at various real-time points, whereby solid foundation for outputting complete voltage and current waveforms including width, shape, amplitude, energy and occurrence time are provided.

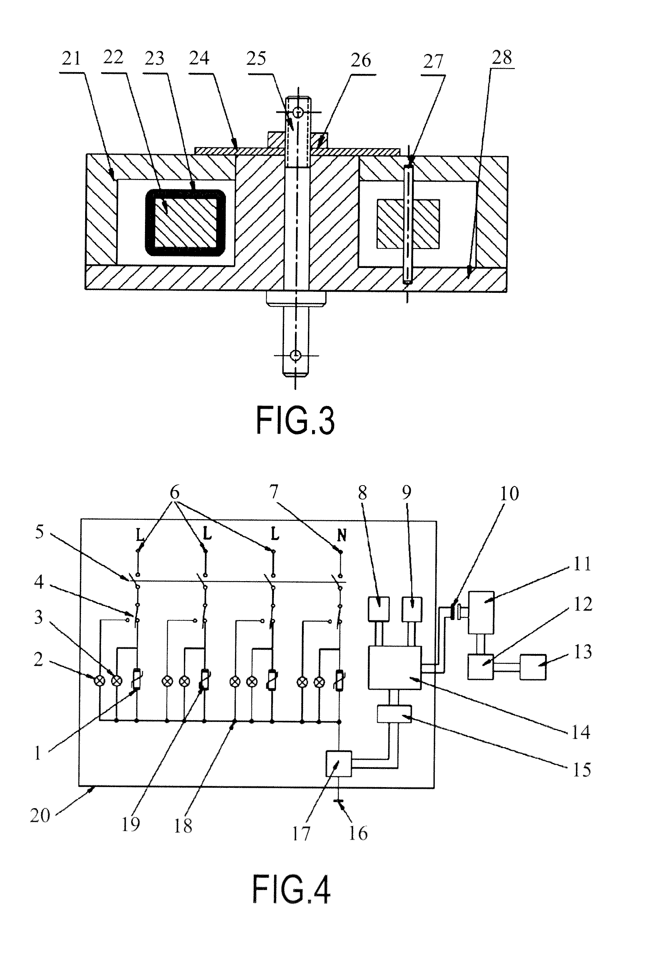

As illustrated in Fig.2 and Fig.3, when such pulse current sensor is applied into the lightning protection cabinet with the function of surge wave recording, the aforementioned semi-circular magnetic cores 22 are supposed to be mounted in the cavity that is formed by the insulating frame 28 and the magnetic shielding housing 21. The detected conductor is the conducting pole 25 that is mounted at the insulating frame 28. Specifically, when preparing such pulse current sensor, the conducting pole 25 acting as primary coil winding is fixedly mounted at the insulating frame 28 and an insulating spacer 24 is mounted at one end of the conducting pole 25; said insulating spacer 24 is fastened by the gland nut 26. Moreover, the insulating frame 28 is connected with the magnetic shielding housing 21; in the cavity that is formed by the insulating frame 28 and the magnetic shielding housing 21, a pair of semi-circular magnetic cores 22 are fixedly mounted by the nonmagnetic bolt 27; the secondary winding 23 is wound around the semi-circular magnetic cores 22; the two nonmagnetic conductive metal rings 29 are respectively installed in the two symmetrical air gaps between the two semi-circular magnetic cores 22; the inner hole axes of said nonmagnetic conductive metal rings 29 are consistent with the magnetic force lines of the semi-circular magnetic cores 22 and the air gaps 30.

The working principle of the lightning protection cabinet with the function of surge wave recording is explained as follows:

Said conducting pole 25 acts as the primary coil winding of such pulse current sensor; the coils 23 wound around the two semi-circular magnetic cores 22 is the secondary coil winding of such pulse current sensor; the two nonmagnetic conductive metal rings 29 respectively installed in the two symmetrical air gaps between the two semi-circular magnetic cores 22 act as degaussing coil windings. When a pulse current passes through the conducting pole 25 as the primary coil winding, induced voltage will appear in the two secondary coil windings which are wound around the two semi-circular magnetic cores 22. The pulse current passing through the primary winding conducting pole 25 can be recovered by integrating the induced voltage. Thanks to the application of the pulse current sensor 17 as illustrated in Fig.1, the measurement range can be improved, and consequently an intact waveform pattern can be acquired.

Based on the pulse current sensor 17, a kind of lightning protection cabinet with the function of surge wave recording is further provided in this invention. As illustrated in Fig.4, there are three phase lines 6, zero line 7, wiring terminal 18 and grounding line 16 arranged in the shell 20 of such lightning protection cabinet with the function of surge wave recording; the phase lines 6 and zero line 7 are all connected with grounding line 16, which is also electrically connected with the shell and to the earth, wherein a plurality of switches 5, thermal trip relays 4 and electrodes 1 are all respectively installed in series connection with every phase line 6 and zero line 7, and wherein semiconductor chips 19 are mounted between the two poles of the corresponding electrodes, to make sure every semiconductor chip 19 is able to be connected with the grounding line 16.

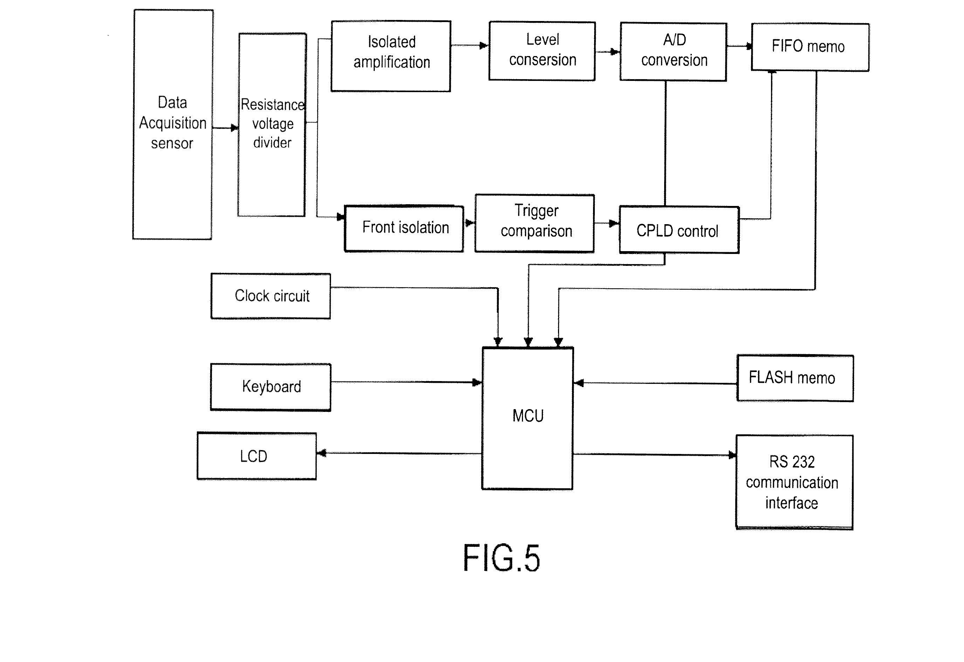

In the present invention, the pulse current sensor 17 is mounted on the grounding line 17 to acquire the data of to-earth discharge voltage and to-earth discharge current. The voltage at the output end of the pulse current sensor 17 is first divided by resistance voltage divider and then is fed into two channels. As illustrated in Fig.5, in one channel, the signal undergoes processing including isolated amplification, level conversion, A/D conversion, and then is sent into MCU 14 via FIFO memory; At the same time, in the other channel, the signal undergoes processing including front isolation, trigger comparison, CPLD control, and later is sent into MCU 14 via FIFO memory. The peripheral equipments of the MCU 14 include clock circuit and FLASH memory. The output of MCU 14 is connected to LCD 8.

It should be pointed out that the output end of MCU 14 can be connected with peripheral computer system 11 via communication interface 10. Said communication interface 10 can be either RS232 interface or 485 interface. With aforementioned connection, such peripheral computer system 11 can implement remote control, and the processed data can be displayed on the peripheral display equipment 12 or printed out by the printer 13 as well.

Moreover, the power lines of working indicators can be connected to each phase line 6 and zero line 7. There are two types of working indicators: one is failure indicator and the other is normal-working indicator. Indicator control circuit is driven by thermal trip relay 4; at the same time, to make sure that the equipments can still work normally when the power supply is cut off, MCU 14 is connected with back-up battery 9.

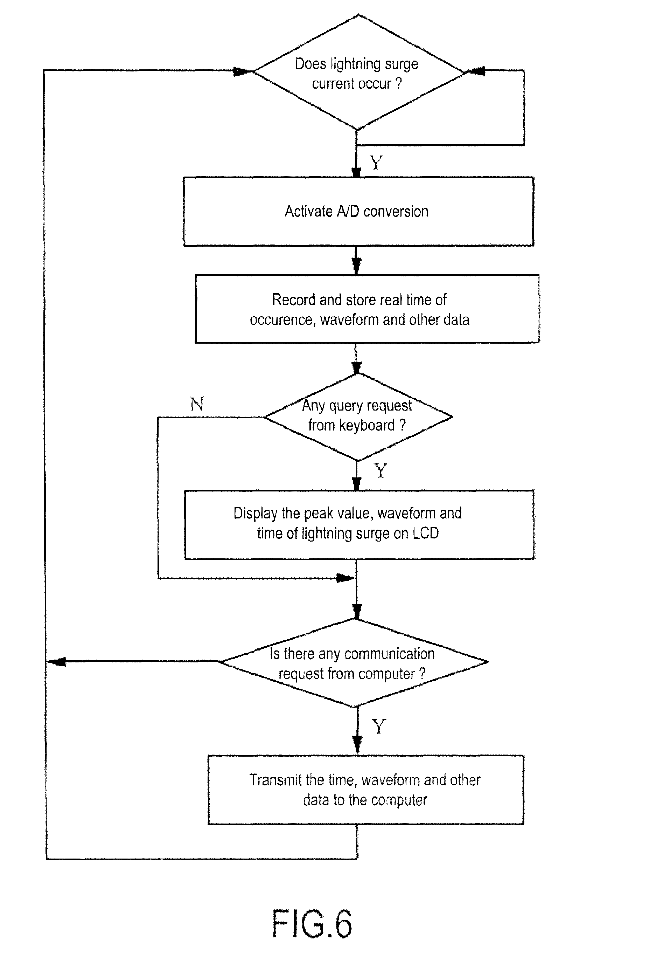

Based on the aforementioned technical scheme, when a lightning surge or electric surge occurs, semiconductor chips 19 will be actuated to be in conducting state, whereby electric discharging to ground along grounding line 16 is allowed. The data acquired by the pulse current sensor 17 that is mounted on the grounding line undergo one process of voltage division by resistance voltage divider, isolated amplification, level conversion, A/D conversion, and meantime undergo the other process of front isolation, trigger comparison, CPLD control, later the processed data will be stored in the FLASH memory via MCU and will be displayed on the screen. The computer system is connected with MCU via RS232 communication interface. As illustrated in Fig.6, the computer software system can transmit the data including the fully recorded waveform pattern, time, and other parameters into the computer; all the recorded data can be displayed, item by item, on the monitor having parametric coordinate system and the waveform, real time and history records can be printed out as well. Based on the above-mentioned processes, the accidents caused by some electric surge or lightning surge can be visually analyzed and judged.

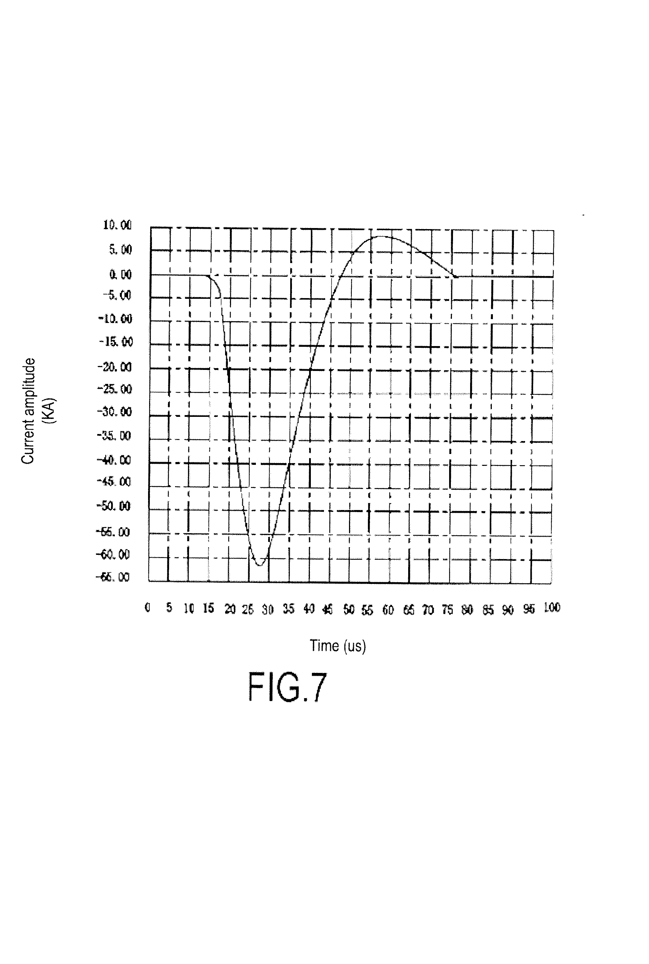

In the embodiment as illustrated in Fig.7, the displayer shows the current waveform of an electric surge in a plane coordinate system and the table 1 shows such electric surge's parameters including peak value of current, inverse peak value, wave front time, wave tail time, specific energy, quantity of electric charge.

**Table 1**

| Test time | peak value of current (KA) | Inverse peak value of current (%) | Wave front time (us) | Wave tail time (us) | Specific energy (KJ/Ω) | Quantity of electric charge (As) |
|---|---|---|---|---|---|---|
| March.2, 10 09:53:49 | 62.09 | 15.28 | 7.80 | 20.09 | 52 | 1.24 |

## Claims

1. A kind of pulse current sensor **characterized in that** it includes a pair of semi-circular magnetic cores (22) which are installed oppositely, air gaps (30) between the two semi-circular magnetic cores (22), and a pair of nonmagnetic conductive metal rings (29) respectively sleeved outside the corresponding air gaps (30);
wherein the inner hole axes of said nonmagnetic conductive metal rings (29) are consistent with the magnetic force lines of the semi-circular magnetic cores (22), and
wherein coils (23) are wound around the semi-circular magnetic cores (22), with output terminals (31) led out from the coils (23).

2. A kind of pulse current sensor as defined in claim 1, **characterized in that** said semi-circular magnetic cores (22) are mounted in the cavity that is formed by an insulating frame (28) and a magnetic shielding housing (21).

3. A kind of pulse current sensor as defined in claim 2, **characterized in that** a conducting pole (25) is mounted on said insulating frame (28).

4. A kind of lightning protection cabinet, which adopts the pulse current sensor as defined in claim 3 and has the function of surge wave pattern recording, **characterized in that** it comprises: a plurality of switches (5), thermal trip relays (4) and electrodes (1), all of which being respectively installed in series connection with every phase line (6) and zero line (7), and semiconductor chips (19) disposed between the two poles of said electrodes (1);
wherein said phase lines (6) and zero line (7) are all connected with a grounding line (16);
wherein the pulse current sensor (17) is mounted on said grounding line (16) and connected with an MCU (14) through an A/D conversion interface (15), said MCU 14 being connected with a display screen (8).

5. A kind of lightning protection cabinet as defined in claim 4, **characterized in that** said MCU (14) is connected with a computer system (11) by a communication interface (10), the computer system (11) connected with a equipment (12) and a printer (13).

6. A kind of lightning protection cabinet as defined in claim 5, **characterized in that** said communication interface (10) is a RS232 interface.

7. A kind of lightning protection cabinet as defined in claim 6, **characterized in that** said MCU 14 is still connected with a back-up battery (9).

8. A kind of lightning protection cabinet as defined in claim 7, **characterized in that** a failure indicator (2) and a normal-working indicator (3) are both installed on each of said phase line (6) and zero line (7).
